# EUROPEAN PATENT APPLICATION

(11) **EP 0 685 875 A2**
(43) Date of publication of application: **06.12.1995**
(21) Application number: 95303503.7
(22) Date of filing: 24.05.1995
(51) Int. Cl.: H01L 21/00, H01L 21/56

(54) **Sealing arrangement for mold**

(30) Priority: 02.06.1994 US 252816
(71) Applicant: AT&T Corp., New York, NY 10013-2412 (US)
(72) Inventor: Shevchuk, George J., Matawan, New Jersey 07747 (US)
(74) Representative: Johnston, Kenneth Graham

(57) **Abstract**

An arrangement (10) for overmolding an article which extends beyond the mold cavity itself is provided with first and second mold portions arranged on opposing sides of a first portion of the article, which is contained within the mold cavity. A portion of deformable material (26-29) is disposed in the region where the mold halves interface with a second portion of the article, which extends beyond the mold cavity. When the mold halves are clamped down in a conventional manner the deformable material forms a seal in the area of the second portion of the article which prevents the molding compound, which is injected into the mold cavity under pressure, from escaping in the vicinity of the second portion of the article. This arrangement is particularly adaptable to molding integrated circuits of the type which are installed on leadframes which extend beyond the mold cavity. Similarly, the arrangement can be used to overmold optical devices which have optical conduits extending beyond an overmolded portion.

## Description

### Background of the Invention

### FIELD OF THE INVENTION

This invention relates generally to packaging technology, and more particularly, to an arrangement for effecting molded encapsulation of integrated circuits, optical devices and other articles.

### DESCRIPTION OF THE RELATED ART

When it is desired to overmold a portion of an article, there is always a problem in obtaining an adequate seal at the extremities of the encapsulation, particularly where the remaining portion of the article extends beyond the mold. One area of technology which must address this problem is the production of plastic packaging for integrated circuit devices. Conventional plastic packaging of integrated circuit devices involves the overmolding of the package onto a leadframe assembly. The electronic integrated circuit is contained within a mold cavity with portions of the leadframe assembly extending outside thereof. The mold is then injected with a plastic compound under pressure. The portion of the leadframe which extends beyond the mold cavity generally consists of a plurality of spaced-apart leads. Some structure must be provided to prevent the packaging compound from escaping from the mold cavity in the region of the leads.

In a conventional arrangement for achieving plastic packaging for integrated circuits, two mold halves are arranged on either side of the integrated circuit and the outward-extending portion of the leadframe. Seals are achieved in the regions intermediate of the leads by the provision of dam bars. Dam bars are simply webs between adjacent pairs of leads, formed out of the leadframe material itself. The dam bars are located external to the cavity, and are clamped along with the remainder of the external portion of the leadframe. The dam bars serve to provide containment of the molding compound that otherwise would flow into the spaces between adjacent leads. Subsequent to molding, the dam bars are trimmed out, along with the small pieces of molding flash between the dam bars and the edge of the molded body.

There are several situations where the use of dam bars is undesirable. One is in the case of fine-pitch components. As the space between the leads decreases, punch tools needed to trim out the dam bar segments become more delicate and require more precise alignment. This adds significantly to the cost and complexity of the trimming process. A second situation where dam bars are problematical is in cases where multiple components are to be mounted onto a leadframe. In such a case, it is often desirable to test a partial assembly before attaching the final, and oftentimes expensive, components, and, of course, prior to molding the package. The dam bars preclude such testing of the partial assembly because they interconnect the leads electrically.

One known approach for eliminating the need for dam bars involves the provision of structure to at least one of the molds parting surfaces which will perform the dam bar function with features of the mold itself, as opposed to features of the leadframe. Small protrusions are provided on the mold surface between regions where adjacent leads would lie. These small protrusions in the mold have been commonly referred to as "hibbles."

The use of hibbles produces a number of significant problems. First, as a result of the large thermal expansion that a leadframe undergoes in a hot mold, particularly along its length, special care and attention is required for use of such hibbles with a leadframe design wherein the leads are oriented perpendicular to the length of the strip. In such a leadframe configuration, the leads furthest from the tooling holes shifts significantly from their cold positions during warmup if the leadframes are not sufficiently preheated. This results in the leads not being spaced evenly within the regions designated for the leads, and oftentimes the leads partially overlie the hibbles themselves. If the leads are not centered between the hibbles, the side with the excess clearance may permit the molding compound to escape, usually in the form of a flash.

A further problem with the use of hibbles is that they are of a predetermined and fixed height from the surface of the mold, and therefore cannot accommodate anything other than nominal variances in the thickness of the leadframe. In situations where the leadframe is slightly on the thick side, the hibbles do not shut off against the other mold half, and therefore the molding compound is permitted to escape in the regions between the top surface of the hibbles and the surface of the other mold half. On the other hand, if the leadframe is slightly thin, then molding compound might be permitted to escape in the region of the leads. Similarly, flashing may occur along the sides of the leads and the sides of the hibbles when the leads are not sufficiently wide to cover the lead region within specifications, or, as stated, when the leads have shifted their position due to heat.

The foregoing makes clear that there is a need in the art for a system for molding integrated circuit chips and other articles which extend beyond the mold cavity and where it is desired to achieve a seal in the region where a portion of the article being overmolded is intermediate of the mold halves.

It is, therefore, an object of this invention to provide an arrangement for overmolding integrated circuitry installed on a leadframe which extends beyond the perimeter of the mold cavity, and wherein escape of a molding compound is prevented at such perimeter.

It is another object of this invention to provide a sealing arrangement for an article mold whereby flashing or other forms of escape of the molding material are prevented.

It is also an object of this invention to provide a mold for overmolding an optical device having a light conduit extending beyond the perimeter of the mold.

It is a further object of this invention to provide a mold for molding an article having a portion which extends beyond the perimeter of the mold cavity, and which effects a seal at such perimeter.

It is additionally an object of this invention to provide a mold which is tolerant of manufacturing variances in portions of overmolded devices which extend beyond the perimeter of the mold cavity.

It is yet a further object of this invention to provide a system for overmolding integrated circuit devices arranged on leadframes, wherein some assemblies of the integrated circuitry can be tested prior to such molding.

It is also another object of this invention to provide an arrangement for overmolding a leadframe wherein the leadframe is not provided with dam bars.

It is yet an additional object of this invention to provide a mold which does not employ hibbles to effect interlead mold sealing.

### Summary of the Invention

The foregoing and other objects are achieved by this invention which provides a mold for an integrated circuit package of the type wherein an integrated circuit chip is arranged on a leadframe. The integrated circuit chip and a portion of the leadframe are contained within the cavity portion of the mold and are overmolded with a molding compound which enters the mold under pressure. The leadframe has a plurality of spaced-apart leads extending therefrom and beyond the overmolded portion of the leadframe. In accordance with the invention, first and second mold portions are arranged on opposing sides of the integrated circuit chip and the leadframe for defining a mold volume which is to be filled with the molding compound. The first and second mold portions interface with one another at an interfaced region wherein respective parting surfaces of the first and second mold portions are disposed on opposite sides of a plurality of spaced-apart leads. One of the mold portions has a depression formed therein extending along the interfaced region. A portion of deformable material is disposed in the depression and extends outward thereof toward the other mold half. by an amount which is predetermined in response to the thickness of the spaced-apart leads which extend beyond the overmolded portion of the leadframe. Thus, when the first and second mold portions are urged toward one another, the portion of the deformable material is deformed to form a seal in the vicinity of such spaced-apart leads.

The accommodation of the spaced-apart leads by the deformable material yields a plurality of hibbles formed of the deformable material and disposed between the spaced-apart leads. The height of the hibbles conforms to the predetermined leadframe thickness.

In one embodiment of the invention, the deformable material is polyphenylene sulfide (PPS). This material contains approximately between 5% and 20% polytetrafluoroethylene (PTFE). In a further embodiment of the invention, the deformable material is polyphthalamide. This material may also contain approximately between 5% and 20% PTFE. Other suitable materials may be employed. PPS and polyphthalamide are commercially available, such as from RTP Engineering Products, 580 East Front Street, Winona, MN 55987-5439.

In accordance with a further aspect of the invention, a mold is provided for an optical circuit package of the type having an optical device overmolded with a molding compound which enters the mold under pressure. The optical device is of the type which has an optical conduit extending therefrom and beyond the mold. In accordance with the invention, first and second mold portions are arranged on respective opposing sides of the optical device for the finding a mold volume which is to be filled with the molding compound. The first and second mold portions interface with one another in an interface region wherein respective parting surfaces of the first and second mold portions are arranged on opposite sides of the optical conduit. At least one of the first and second mold portions has a depression formed therein extending along the interface region. A portion of the deformable material is arranged in a depression and extends outward thereof by a predetermined amount which is predetermined in response to the thickness of the optical conduit which extends beyond the mold volume. As the first and second mold portions are urged toward one another, the deformable material is deformed to form a seal in the vicinity of the optical conduit.

In some embodiments of the invention, a plurality of optical devices, each having an associated optical conduit, are provided and are arranged within the mold volume. The plural optical conduits extend outward of the mold region and, in some embodiments are parallel to one another. The deformable material, therefore, creates in this embodiment a plurality of outwardly extending optical conduits.

As previously discussed, the deformable material may be PPS, polyphthalamide, or other suitable materials. In other embodiments, either or both of these deformable materials may be provided with approximately between 5% and 20% PTFE.

In accordance with a further embodiment of the invention, there is provided an arrangement for overmolding a portion of an article, the article having a second portion which extends outward of the first portion. In accordance with the invention, first and second mold portions are arranged on respective opposing sides of the first portion of the article for defining a mold volume and for enclosing the first portion of the article. The mold volume is to be filled with the molding compound. The first and second mold portions interface one another in an interface region wherein respective parting surfaces of the first and second mold portions are arranged on opposite sides of the second portion of the article. A portion of the deformable material is disposed in the interface region whereby when the first and second mold portions are urged towards one another, the portion of the deformable material is deformed to form a seal in the vicinity of the second portion of the article.

In one embodiment, one of the first and second mold portions has a depression therein in the vicinity of the interfaced region. The depression accommodates the portion of the deformable material. In some embodiments, the depression is a groove arranged on one of the first and second mold portions for receiving the deformable material. In such an embodiment, the deformable material is configured cross-sectionally to correspond with the cross-sectional configuration of the groove, except for space which may be provided to accommodate the material which is displaced. The deformable material extends outward of the groove by an amount which is predetermined in response to the thickness of the second portion of the article.

As set forth hereinabove with respect to certain other embodiments of the invention, the deformable material is PPS or polyphthalamide. Approximately between 5% and 20% PTFE may be incorporated into the deformable material.

### Brief Description of the Drawing

Comprehension of the invention is facilitated by reading the following detailed description, in conjunction with the annexed drawing, in which:
Fig. 1 is an isometric representation of a mold arrangement for an integrated circuit installed on a leadframe; and
Fig. 2 is an isometric representation of a portion of a mold for overmolding an optical device with optical conduits extending therefrom.

### Detailed Description

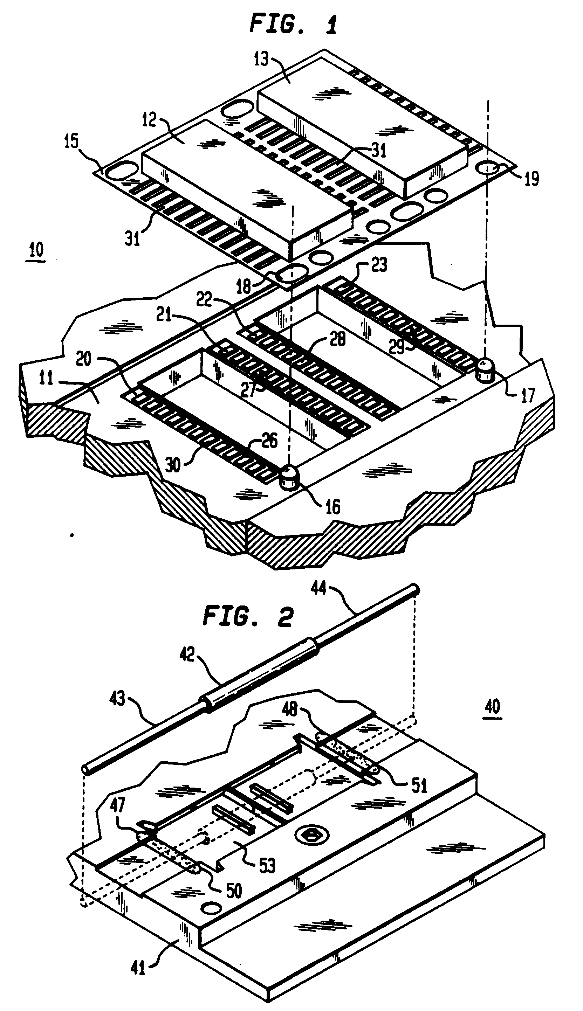

Fig. 1 is a fragmented isometric representation of a mold arrangement 10 constructed in accordance with the principles of the invention. As shown, mold arrangement 10 has, in this specific illustrative embodiment, a lower mold portion 11. The upper mold portion is not shown in this figure.

Fig. 1 shows molded integrated circuit chips 12 and 13 which contain therewithin one or more respective integrated circuits (not shown) which are mounted on leadframe 15. The figure shows the integrated circuit chips being removed from a mold, specifically lower mold portion 11. Alignment of the leadframe with respect to the lower mold portion is achieved by alignment posts 16 and 17 which engage which apertures 18 and 19, respectively, of leadframe 15.

This figure shows grooves 20, 21, 22, and 23, each of which accommodates a respective one of deformable strips 26, 27, 28, and 29. Deformable strip 26 which in this embodiment is identical to the others, is shown to have formed a plurality of hibbles 30 which, during the molding process, were arranged between leads 31 of leadframe 15. The hibbles which, during molding, were disposed between the mold halves, prevented the escape of the molding compound. The molding compound may be a conventional material, such as the well-known Sumitomo 6300HD, at conventional molding pressures, such as approximately between 600 to 1,500 psi.

Fig. 2 is an isometric representation of a specific illustrative embodiment of the invention. A mold arrangement 40 is provided with a lower mold portion 41 which is employed to overmold an optical device 42 having light conduits 43 and 44 extending therefrom. The broken lines illustrate the manner in which optical device 42 is arranged on lower mold portion 41. Lower mold portion 41 has impressions 47 and 48 in its parting surface which are filled with portions 50 and 51, respectively, of a deformable material. The deformable material may be polyphenylene sulfide (PPS), and in other embodiments of the invention, may be polyphthalamide or other materials. These deformable materials may contain approximately between 5% and 20% PTFE.

During clamping of the mold, the portions of deformable material around optical conduits 43 and 44 and form a seal which prevents the molding compound (not shown) which is injected into molding volume 53 from escaping along the optical conduits.

Although the invention has been described in terms of specific embodiments and applications, persons skilled in the art can, in light of this teaching, generate additional embodiments without exceeding the scope or departing from the spirit of the claimed invention. Accordingly, it is to be understood that the drawing and description in this disclosure are proffered to facilitate comprehension of the invention, and should not be construed to limit the scope thereof.

## Claims

1. A mould for an integrated circuit package of the type wherein an integrated circuit chip is arranged on a leadframe, the integrated circuit chip and a portion of the leadframe being contained within the mold and overmolded with a molding compound which enters the mold under pressure, the leadframe having a plurality of spaced-apart leads extending therefrom and beyond the overmolded portion of the leadframe, the mold comprising:
first and second mold portions arranged on respective opposing sides of the integrated circuit chip and the leadframe for defining a mold volume to be filled with the molding compound, said first and second mold portions interfacing with one another in an interface region wherein respective parting surfaces of said first and second mold portions interface on opposite sides of the plurality of spaced-apart leads, one of said first and second mold portions having a depression formed therein extending along the interface region; and
a portion of deformable material disposed in said depression and extending outward thereof by a predetermined amount which is predetermined in response to the thickness of the spaced-apart leads extending beyond the overmolded portion of the leadframe, whereby when said first and second mold portions are urged toward one another, the portion of deformable material is deformed to form a seal in the vicinity of each such spaced-apart lead.

2. A mold for an optical circuit package of the type wherein an optical device is overmolded with a molding compound which enters the mold under pressure, the optical device having an optical conduit extending therefrom and beyond the mold, the mold comprising:
first and second mold portions arranged on respective opposing sides of the optical device for defining a mold volume to be filled with the molding compound, said first and second mold portions interfacing with one another in an interface region wherein respective parting surfaces of said first and second mold portions are arranged on opposite sides of the optical conduit, one of said first and second mold portions having a depression formed therein extending along the interface region; and
a portion of deformable material disposed in said depression and extending outward thereof by a predetermined amount which is predetermined in response to the thickness of the optical conduit extending beyond the mold volume, whereby when said first and second mold portions are urged toward one another, the portion of deformable material is deformed to form a seal in the vicinity of the optical conduit.

3. A mold arrangement for overmolding a first portion of an article, the article having a second portion which extends outward of the first portion, the arrangement comprising:
first and second mold portions arranged on respective opposing sides of the first portion of the article for defining a mold volume for enclosing the first portion of the article, said mold volume to be filled with the molding compound, said first and second mold portions interfacing with one another in an interface region wherein respective parting surfaces of said first and second mold portions are arranged on opposite sides of the second portion of the article; and
a portion of deformable material disposed in said interface region, whereby when said first and second mold portions are urged toward one another, the portion of deformable material is deformed to form a seal in the vicinity of the second portion of the article.

4. The mold of claim 1 wherein said deformable material is deformed to produce a plurality of hibbles arranged between the spaced-apart leads.

5. The mold of claim 1 wherein the leadframe has a predetermined leadframe thickness and said plurality of hibbles each develop a height which is responsive to said predetermined leadframe thickness.

6. The mold or arrangement of claim 1, 2 or 3, wherein said deformable material is polyphenylene sulfide (PPS), or polyphthalamide.

7. The mold or arrangement of claim 6, wherein said polyphenylene sulfide or polyphthalamide contains approximately between 5% and 20% PTFE.

8. The arrangements of claim 2, wherein a plurality of optical conduits extend beyond the mold in said interface region, and said deformable material is deformed to form a seal in the vicinity of said plurality of optical conduits.

9. The arrangement of claim 3, wherein one of said first and second mold portions has a depression therein in the vicinity of said interface region, for accommodating said portion of deformable material.

10. The arrangement of claim 9, wherein said depression comprises a groove in one of said first and second mold portions, and said portion of deformable material is configured cross-sectionally to correspond with a cross-sectional configuration of said groove, and extending outward therefrom by an amount which is predetermined in response to a thickness dimension of the second portion of the article.
